# EUROPEAN PATENT APPLICATION

(11) **EP 4 832 696 A1**
(43) Date of publication of application: **28.10.2026**
(21) Application number: 26170669.1
(22) Date of filing: 02.04.2026
(51) Int. Cl.: H10F 55/25, G01S 7/48, G01S 7/481, G01S 7/484, G01S 7/486, G01S 7/4861, G01S 17/89

(54) **PACKAGE DESIGN FOR OPTICAL RANGING SENSOR DIE**

(30) Priority: 16.04.2025 US 202519180436
(71) Applicant: STMicroelectronics International N.V., 1228 Plan-les-Ouates, Geneva (CH)
(72) Inventor: MAO, Yandong, Shanghai, 200240 (CN); TEO, Tat Ming, 797463 Singapore (SG)
(74) Representative: Casalonga

(57) **Abstract**

An optical ranging sensor die, optical ranging sensor package, and a method for determining a physical property of a target object using an optical ranging sensor package are provided. An example optical ranging sensor die includes an integrated circuit die and an optical source. The integrated circuit die includes a first surface, a second surface opposite the first surface, and one or more sides. The first surface integrating an optical source contact surface and an optical receiver. The one or more sides defining an outer perimeter, wherein the outer perimeter of the integrated circuit die defines an outer boundary of the optical ranging sensor die. The optical source electrically connected to the optical source contact surface and configured to transmit an optical signal toward a target object, wherein a physical property of the target object is determined based on the optical signal received at the optical receiver.

## Description

### TECHNOLOGICAL FIELD

Embodiments of the present disclosure relate generally to optical ranging sensors, and more particularly, to a design of an optical ranging sensor die for an optical ranging sensor.

### BACKGROUND

Optical ranging sensors, or time-of-flight sensors, have widespread applications across multiple industries due to their ability to measure distances, track objects, detect presence, and/or map environments with high precision. For example, optical ranging sensors may be used in consumer electronics for facial recognition, augmented reality, and enhanced focus of a camera. In robotics and autonomous vehicles, time-of-flight sensors may enable obstacle avoidance, improved navigation, and safety through real-time 3D mapping of a surrounding environment. In industrial automation, time-of-flight sensors may be used for precise object detection and monitoring. As applications requiring optical ranging sensors continue to grow, there is an increased desire for easier and cheaper development of these sensors with reduced form factor.

Applicant has identified many technical challenges and difficulties associated with a design of optical ranging sensor dies. Through applied effort, ingenuity, and innovation, Applicant has solved problems related to the design of optical ranging sensor dies by developing solutions embodied in the present disclosure, which are described in detail below.

### BRIEF SUMMARY

Various embodiments are directed to an example optical ranging sensor die, an example optical ranging sensor package, and a method for determining a physical property of a target object using an optical ranging sensor package.

An example optical ranging sensor die is provided. The example optical ranging sensor die comprising an integrated circuit die and an optical source. The integrated circuit die comprising a first surface, a second surface opposite the first surface, and one or more sides. The first surface comprising an optical source contact surface; and an optical receiver. The one or more sides defining an outer perimeter, wherein the outer perimeter of the integrated circuit die defines an outer boundary of the optical ranging sensor die. The optical source electrically connected to the optical source contact surface and configured to transmit an optical signal toward a target object, wherein a physical property of the target object is determined based on the optical signal received at the optical receiver.

In some embodiments, the optical source is electrically connected to the optical source contact surface of the integrated circuit die in a flip-chip configuration.

In some embodiments, the optical source comprises a vertical-cavity surface-emitting laser (VCSEL).

In some embodiments, the integrated circuit die is manufactured using a wafer-level chip-scale process.

In some embodiments, the first surface comprises an optical source portion and an optical receiver portion, wherein one or more electrical components are attached to the optical source portion of the first surface.

In some embodiments, the optical ranging sensor die further comprises a redistribution layer, wherein the redistribution layer is attached to the second surface of the integrated circuit die.

In some embodiments, a bottom surface of the redistribution layer comprises one or more electrical contact points electrically connected to the integrated circuit die.

An optical ranging sensor package is further provided. In some embodiments, the optical ranging sensor package comprises an optical ranging sensor die, an optical source, a protective can, and a cap. The optical ranging sensor die comprising an integrated circuit die and an optical source. The integrated circuit die comprising a first surface, a second surface opposite the first surface, and one or more sides. The first surface comprising an optical source contact surface, and an optical receiver. The one or more sides defining an outer perimeter, wherein the outer perimeter of the integrated circuit die defines an outer boundary of the optical ranging sensor die. The optical source electrically connected to the optical source contact surface and configured to transmit an optical signal toward a target object, wherein a physical property of the target object is determined based on the optical signal received at the optical receiver. The protective can covering at least a portion of the first surface of the optical ranging sensor die, the protective can comprising a transmission opening aligned with the optical source, and a receiving opening aligned with the optical receiver. The cap attached to the protective can.

In some embodiments, the cap comprises a transmission cavity comprising a cap transmission opening, wherein the cap transmission opening is aligned with the transmission opening of the protective can; and a receiving cavity comprising a cap receiving opening, wherein the cap receiving opening is aligned with the receiving opening of the protective can.

In some embodiments, the cap further comprises a barrier wall dividing the transmission cavity from the receiving cavity.

In some embodiments, the optical ranging sensor die further comprises a redistribution layer, wherein the redistribution layer is attached to the second surface of the integrated circuit die.

In some embodiments, a bottom surface of the redistribution layer comprises one or more electrical contact points electrically connected to the integrated circuit die.

In some embodiments, the one or more electrical contact points are electrically connected to a printed circuit board.

In some embodiments, the protective can is attached to the printed circuit board.

In some embodiments, the can comprises kovar.

In some embodiments, the optical source is electrically connected to the optical source contact surface of the integrated circuit die in a flip-chip configuration.

In some embodiments, the optical source comprises a vertical-cavity surface-emitting laser (VCSEL).

In some embodiments, the integrated circuit die is manufactured using a wafer-level chip-scale process.

In some embodiments, the first surface comprises an optical source portion and an optical receiver portion, and wherein one or more electrical components are attached to the optical source portion of the first surface.

A method for determining a physical property of a target object is further provided. In some embodiments, the method comprising providing an optical ranging sensor package comprising an optical ranging sensor die, a protective can, and a cap. The optical ranging sensor die comprising an integrated circuit die and an optical source. The integrated circuit die comprising a first surface comprising an optical source contact surface and an optical receiver, a second surface opposite the first surface; and one or more sides defining an outer perimeter, wherein the outer perimeter of the integrated circuit die defines an outer boundary of the optical ranging sensor die. The optical source electrically connected to the optical source contact surface and configured to generate an optical signal. The protective can covering at least a portion of the first surface of the optical ranging sensor die, the protective can comprising a transmission opening aligned with the optical source, and a receiving opening aligned with the optical receiver. The cap attached to the protective can. The method further comprising transmitting the optical signal toward the target object; receiving the optical signal reflected off the target object; and determining the physical property of the target object based on a time-of-flight of the optical signal.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 depicts a perspective view of an example optical ranging sensor die in accordance with an example embodiment of the present disclosure.
FIG. 2 depicts an exploded view of an example optical ranging sensor package including an optical ranging sensor die in accordance with an example embodiment of the present disclosure.
FIG. 3 depicts a perspective view of an example optical ranging sensor package in accordance with an example embodiment of the present disclosure.
FIG. 4 depicts a top view of an example optical ranging sensor package in accordance with an example embodiment of the present disclosure.
FIG. 5 depicts a bottom view of an example optical ranging sensor package in accordance with an example embodiment of the present disclosure.
FIG. 6 depicts a perspective view of an example protective can covering an optical ranging sensor die comprising a protective can in accordance with an example embodiment of the present disclosure.
FIG. 7 depicts a cross-section view of an example optical ranging sensor die and protective can in accordance with an example embodiment of the present disclosure.
FIG. 8 depicts a perspective view of an example optical ranging sensor package including a protective can in accordance with an example embodiment of the present disclosure.
FIG. 9 depicts a bottom perspective view of an example optical ranging sensor package including a protective cap in accordance with an example embodiment of the present disclosure.
FIG. 10 depicts a cross-section view of an example optical ranging sensor package including a protective can in accordance with an example embodiment of the present disclosure.
FIG. 11 depicts a flow diagram of an example process for determining a physical property of a target object using an optical ranging sensor package in accordance with an example embodiment of the present disclosure.

### DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Various example embodiments address technical problems associated with the design of optical ranging sensor dies and/or optical ranging sensor packages. As understood by those of skill in the field to which the present disclosure pertains, improvements to the design of optical ranging sensor dies and/or optical ranging sensor packages may simplify the manufacturing complexity of an optical ranging sensor package, reduce cost, and/or reduce the size of optical ranging sensor packages.

For example, optical ranging sensors have widespread applications across multiple industries due to their ability to measure distances, track objects, detect presence, and/or map environments with high precision. Optical ranging sensors may be used in consumer electronics for facial recognition, augmented reality, and enhanced focus of a camera. In robotics and autonomous vehicles, optical ranging sensors may enable obstacle avoidance, improved navigation, and safety through real-time 3D mapping of a surrounding environment. In industrial automation, optical ranging sensors may be used for precise object detection and monitoring.

During operation, the optical ranging sensor transmits light from an optical transmitter toward a target object in an external environment. The transmitted light reflects off the target object and is received by an optical receiver on the optical ranging sensor. Based on the time required for the transmitted light to travel to the target object, reflect off the target object, and travel back to the optical ranging sensor, certain physical aspects of the target object may be determined, for example, the distance of the target object, the motion of the target object, the speed of the target object, and so on.

As applications requiring optical ranging sensors continue to grow, there is an increased desire for easier and cheaper development of these sensors. In addition, many space-constrained applications desire smaller sensors in a continued effort to reduce size and weight of electrical components. Further, mechanisms to reduce the transmission and reception of electromagnetic interference (EMI) may improve the accuracy and efficiency of an optical ranging sensor.

In some examples, an optical ranging sensor may be based on a substrate. The top surface of the substrate may be configured to receive an integrated circuit, an optical transmitter, and other electrical components at different contact points of the substrate. Each of these components may be electrically connected to the top surface of the substrate, for example, using wire bond connections. Thus, the top surface of the substrate may be much bigger than the integrated circuit to provide mounting space for the optical transmitter and other electrical components. In addition, wire bond connections may generate disruptive EMI, as well as be susceptible to disruption with the reception of EMI. Further, some examples may require a laser safety trace. A laser safety trace is a metal trace embodied with a transmit lens. The laser safety trace connects to a detection circuit on the sensor to monitor the state of the transmit lens. In an instance in which the transmit lens is broken or moved out of position, the laser safety trace will also break, causing the laser to turn off. Without a laser safety trace, the intensity of light from a VCSEL, may burn the eyes or skin without the transmit lens to diffuse the light.

The various example embodiments described herein utilize various techniques to reduce the size and complexity of an optical ranging sensor, while reducing disruption due to EMI. For example, an integrated circuit die of the optical ranging sensor in accordance with the present disclosure is designed such that all of the electrical components may be integrated within the integrated circuit die and/or interfaced at a top surface of the integrated circuit die. Such a design enables the size of the optical ranging sensor die to be defined by the outer perimeter of the integrated circuit die. As such, the optical ranging sensor package may be reduced in accordance with the outer perimeter of the integrated circuit die. In some embodiments, the optical source and other electrical components of the optical ranging sensor interface with the integrated circuit die through one or more contact surfaces at the top surface of the integrated circuit die. Such a design enables compact design of optical ranging sensors.

In addition, in some embodiments, the various electrical components of the optical ranging sensor may be attached directly to the contact surface of the integrated circuit die without wire bonds. Eliminating wire bonds may greatly reduce EMI received at the optical ranging sensor, as well as EMI generated by the optical ranging sensor electrical components. Further, attaching the various electrical components of the optical ranging sensor directly to the integrated circuit die may eliminated the need for various safety features, such as the laser safety trace. In addition, attaching electrical components to the top surface of the integrated circuit die and removing wire bonds may enable a reduction in the overall profile height of the optical ranging sensor die.

As a result of the herein described example embodiments, the overall size of an optical ranging sensor package may be greatly reduced. In addition, directly attaching the electrical components of the optical ranging sensor to a surface of the integrated circuit die may reduce the complexity of the assembly process of the optical ranging sensor, for example, enabling the optical ranging sensor die to be complete before cutting the integrated circuit die from a wafer of integrated circuits. Further, eliminating wire bonds in the optical ranging sensor die may reduce the impact of EMI at or near the optical ranging sensor.

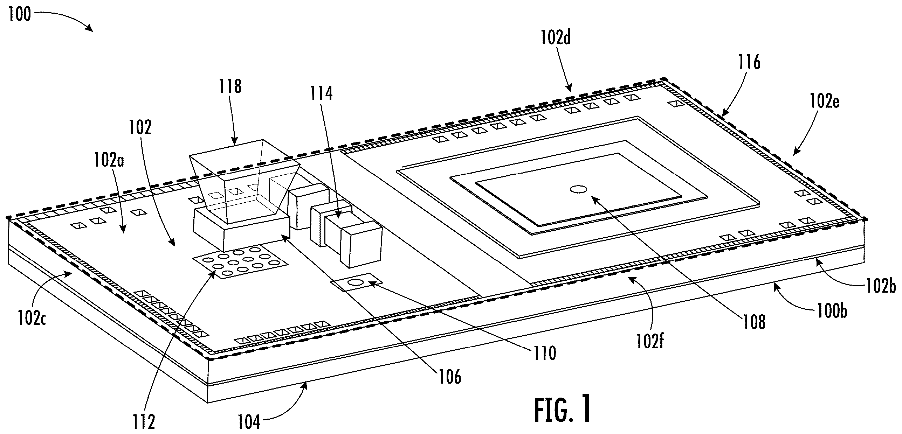

Referring now to FIG. 1, an example optical ranging sensor die 100 is provided. As depicted in FIG. 1, the example optical ranging sensor die 100 includes a integrated circuit die 102 and a redistribution layer 104. The integrated circuit die 102 comprises an optical source contact surface 112 configured to receive an optical source 106. The integrated circuit die 102 further comprises an optical receiver 108 and a reference array 110.

As depicted in FIG. 1, the integrated circuit die 102 defines an outer perimeter 116. Although the integrated circuit die 102 may be any shape, the integrated circuit die 102 of FIG. 1 includes four sides (e.g., side 102c, side 102d, side 102e, side 102f) defining the outer perimeter 116. The integrated circuit die 102 further includes a top surface 102a and a bottom surface 102b.

As further depicted in FIG. 1, the various electrical components 114 and optical source 106 are attached to the top surface 102a of the integrated circuit die 102. Thus, the outer perimeter 116 of the integrated circuit die 102 defines an outer perimeter of the optical ranging sensor die 100.

As further depicted in FIG. 1, a redistribution layer 104 is attached to the bottom surface 102b of the integrated circuit die 102.

In general, an optical ranging sensor operates by measuring the time it takes for an optical signal (e.g., optical signal 118), usually emitted as a laser or infrared pulse, to travel to a target object and reflect back to the optical receiver 108. An optical ranging sensor calculates the distance to the target object based on the speed of light and the time delay between the emission and detection of the optical signal. The characteristics of the reflected optical signal 118 may be used to measure a distance to the target object, track the motion of the target object, determine a speed of the target object, detect presence of a target object, and/or map target objects in an environment with high precision. In general, two arrays (e.g., reference array 110 and optical receiver 108) are needed to determine a time of flight. When an optical signal 118 is emitted, a portion of the optical signal 118 will first bounce inside the internal module cavity and hit the reference array 110. Another portion of the optical signal 118 will continue to travel to a target, reflect off the target, and return to the optical receiver 108. By comparing the time difference between the optical signal 118 received at the reference array 110 and the optical receiver 108, the time of flight of the optical signal 118 may be precisely measured.

As depicted in FIG. 1, the example integrated circuit die 102 of the optical ranging sensor die 100 includes an optical receiver 108. An optical receiver 108 comprises any set of one or more photodiodes, integrated circuits, sensors, light sensing diodes, or other photodetector structures that produce an electric signal as a result of light received at the optical receiver 108. In some embodiments, the optical receiver may comprise one or more single-photon avalanche diodes (SPADs) configured to generate an avalanche current when one or more photons strike the optical receiver. An optical receiver 108 may further comprise a plurality of photodetector structures (e.g., pixels) arranged in a two-dimensional array. Determinations about target objects may be made based on the returning optical signal reflected off one or more target objects, for example, the distance of the target object, the motion of the target object, the speed of the target object, and so on.

As further depicted in FIG. 1, the example integrated circuit die 102 of the optical ranging sensor die 100 includes a reference array 110. A reference array 110 is positioned to receive a portion of the optical signal 118 at the time of transmission directly from the optical source 106. The reference array 110 may be configured to generate a reference signal based on the optical signal 118 received at the reference array 110. The electrical signal generated by the reference array 110 may be compared with the optical signal received at the optical receiver 108 to determine various features of a target.

In some embodiments, the integrated circuit die 102 may be fabricated utilizing wafer-level chip-scale processes. Utilizing wafer-level chip-scale packaging processes may include attaching and interconnecting all electrical components (e.g., electrical components 114, optical source 106) of the optical ranging sensor die 100 before cutting and separating the integrated circuit die 102 from a wafer. In this way, the manufacturing process may be simplified. In addition, the size of the optical ranging sensor die 100 may be compacted.

As depicted in FIG. 1, the optical ranging sensor die 100 includes one or more electrical components 114 attached to the top surface of the 102a of the integrated circuit die 102. One or more passive and/or active electrical components 114 may be required to facilitate operation of an optical ranging sensor. In some embodiments, such electrical components 114 may not be integrated in the integrated circuit die 102. As such, such electrical components 114 may be electrically connected with the integrated circuit die 102 after fabrication of the integrated circuit die 102. Example electrical components 114 may include capacitors, inductors, resistors, and so on.

As further depicted in FIG. 1, the optical source 106 is attached to the top surface 102a of the integrated circuit die 102. The optical source 106 comprises any device, bulb, semiconductor, light emitting diode, laser, or other photon-emitting structure configured to generate an optical signal 118. In some embodiments, an optical source 106 may comprise a semiconductor laser diode, for example, a vertical-cavity surface-emitting laser (VCSEL) and/or an edge emitting laser diode. In general, an optical source 106 may output a coherent light beam upon receipt of a current.

The optical source 106 is electrically connected to the integrated circuit die 102 through one or more optical source contact surfaces 112. The optical source contact surface 112 comprises one or more conductive surfaces on the top surface 102a of the integrated circuit die 102. The optical source contact surface 112 provides a conductive path between the integrated circuit die 102 and the optical source 106. For example, each signal required to operate the optical source 106 may be generated by the integrated circuit die 102 and routed to a different optical source contact surface 112 through which the optical source 106 may receive the various signals.

In some embodiments, the optical source 106 may be configured in a flip-chip configuration. An optical source 106 in a flip-chip configuration is flipped upside down, such that the electrical contact points of the optical source 106 are placed in direct contact with the top surface 102a of the integrated circuit die 102 (e.g., optical source contact surface 112). Since the electrical contact points of the optical source 106 are in direct contact with the optical source contact surface 112, there is no need for bond wires to electrically connect the optical source 106 to the integrated circuit die 102. Thus, the overall height of the optical ranging sensor die 100 may be reduced. In addition, the EMI generated by the optical source 106 and received at the optical source 106 may be greatly reduced.

As depicted in FIG. 1, attaching the optical source 106, and other electrical components 114 to the top surface 102a of the integrated circuit die 102 enables the optical ranging sensor die 100 to be contained within the outer perimeter 116 of the integrated circuit die 102. The outer perimeter 116 is a closed path that encompasses, surrounds, or outlines the two-dimensional shape of the integrated circuit die 102. Attaching the optical source 106 and other electrical components 114 to the top surface 102a of the integrated circuit die 102 prevents the need for additional base substrate to facilitate the connection of the addition components. For example, as depicted in FIG. 1, the outer perimeter 116 is the closed path that encompasses the four sides (e.g., side 102c, side 102d, side 102e, side 102f) of the integrated circuit die 102.

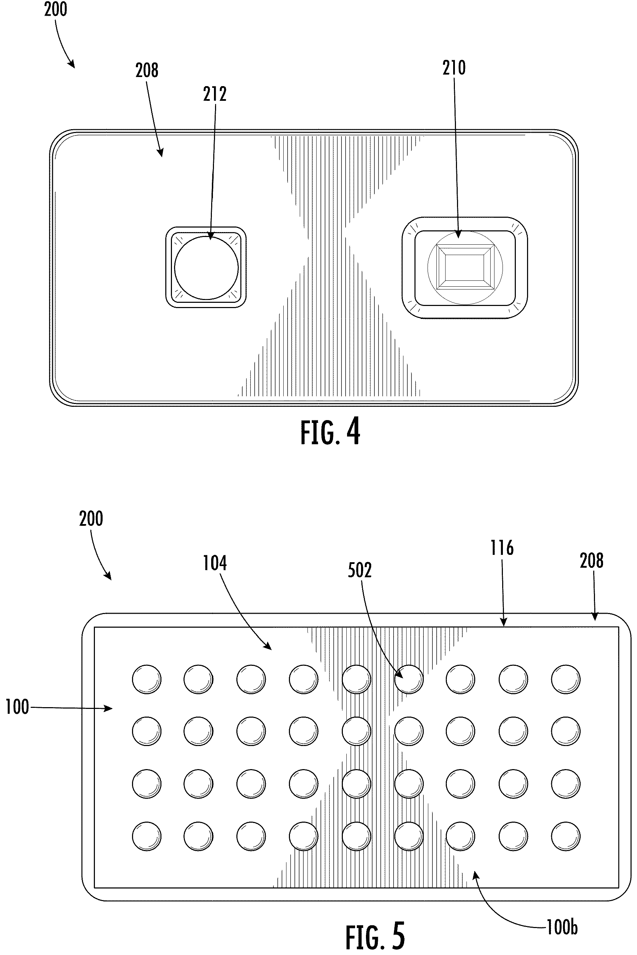

As further depicted in FIG. 1, a redistribution layer 104 is attached to a bottom surface 102b of the integrated circuit die 102. A redistribution layer 104 comprises any material layer comprising one or more conductive paths configured to provide input/output conductive surfaces (e.g., electrical contact points 502 as described in relation to FIG. 5) at a bottom surface 100b of the optical ranging sensor die 100. In some embodiments, the redistribution layer 104 may provide adequate spacing between conductive surfaces to enable an external system (e.g., a printed circuit board) to interface with the conductive surfaces. In some embodiments, the redistribution layer 104 may configured the conductive surfaces to match the interface requirements of an external electrical system.

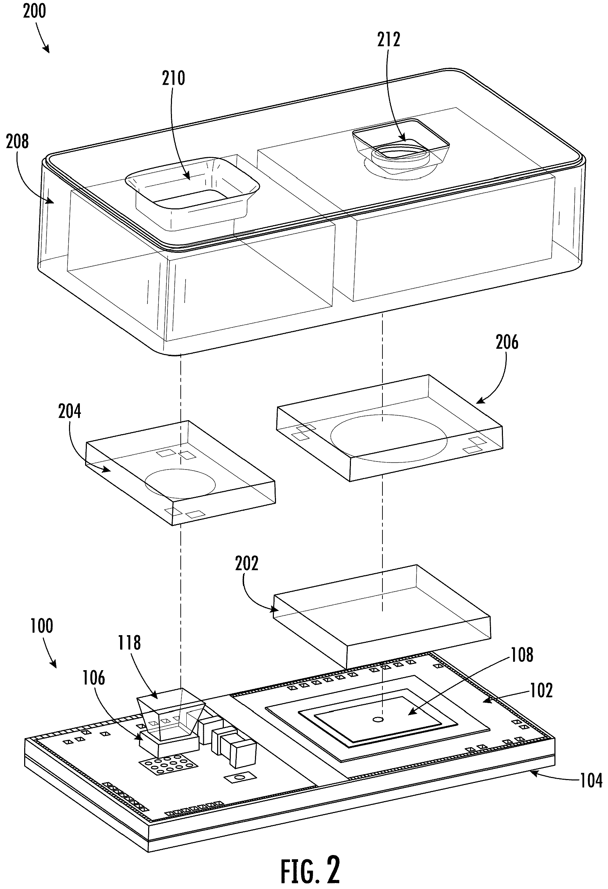

Referring now to FIG. 2, an exploded view of an example optical ranging sensor package 200 is provided. As depicted in FIG. 2, the example optical ranging sensor package 200 includes an optical ranging sensor die 100 including an integrated circuit die 102 and a redistribution layer 104. As further depicted in FIG. 2, the optical ranging sensor package 200 includes a cap 208 comprising a cap receiving opening 212 and a cap transmission opening 210. The cap 208 is configured to attach to the optical ranging sensor die 100 and cover the integrated circuit die 102 and attached electrical components. The cap transmission opening 210 and a transmit lens 204 are attached such that each are aligned with a transmission axis of the optical source 106. Further, the cap receiving opening 212, a receiver lens 206, and a receiver filter 202 are attached such that each are aligned with a receiving axis of the optical receiver 108.

As depicted in FIG. 2, the example optical ranging sensor package 200 includes a cap 208 comprising a cap transmission opening 210 and a cap receiving opening 212. The cap 208 comprises any package, cover, container, or other covering configured to protect the internal electrical components and circuitry of the optical ranging sensor (e.g., optical ranging sensor die 100). A cap 208 may comprise plastic, ceramic, metal, or other protective material. In some embodiments, the cap 208 is attached to the top surface and/or one or more sides of the integrated circuit die 102 to provide stability and further protect the internal electrical components of the optical ranging sensor.

As further depicted in FIG. 2, the cap 208 includes a transmission opening 210 and a receiving opening 212. Openings in the cap 208 may enable the transmission and receipt of optical radiation (e.g., optical signal 118) into and out of the optical ranging sensor package 200. For example, the transmission opening 210 may be aligned with the emission cone of the optical source 106. The optical signal 118 from the optical source 106 may pass through the transmission opening 210 toward a target object in an external environment. Similarly, a receiving opening 212 may enable the receipt of the reflected optical signal 118 into the optical ranging sensor package 200, for example, to be received by the optical receiver 108 and analyzed by a processor or other device.

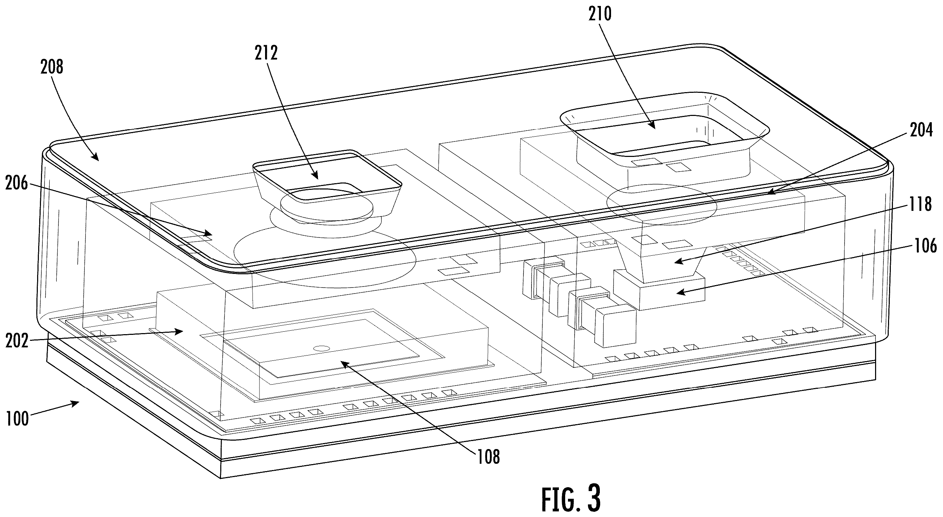

Referring now to FIG. 3, a perspective view of an example optical ranging sensor package 200, including a cap 208, is provided. As depicted in FIG. 3, the example optical ranging sensor package 200 includes an optical ranging sensor die 100. As further depicted in FIG. 3, the optical ranging sensor package 200 includes a cap 208, comprising a cap receiving opening 212 and a cap transmission opening 210, attached to the optical ranging sensor die 100. The cap transmission opening 210 and a transmit lens 204 are attached such that each are aligned with a transmission axis of the optical source 106. Further, the cap receiving opening 212, a receiver lens 206, and a receiver filter 202 are attached such that each are aligned with a receiving axis of the optical receiver 108.

As depicted in FIG. 3, the optical ranging sensor package 200 includes a transmit lens 204. The transmit lens 204 may comprise any optical structure (e.g., glass, plastic, etc.) configured to direct the optical signal 118 through the transmission opening 210 and into an external environment. The optical signal 118 may be shaped and/or steered by the transmit lens 204 based on an application.

As further depicted in FIG. 3, the optical ranging sensor package 200 includes a receiver lens 206. The receiver lens 206 may comprise any optical structure (e.g., glass, plastic, etc.) configured to focus a reflected portion of the optical signal 118 at the optical receiver 108. The optical ranging sensor package 200 may further include a receiver filter 202 configured to filter portions of light entering the receiving opening 212. The receiver filter 202 may filter incoming light based on wavelength, polarization, direction, and/or other properties of the incoming light.

Referring now to FIG. 4, a top view of an example optical ranging sensor package 200 comprising a cap 208 is provided. As depicted in FIG. 4, the cap 208 includes a cap transmission opening 210 configured to enable the transmission of an optical signal into an external environment. As further depicted in FIG. 4, the cap 208 includes a cap receiving opening 212 configured to enable the transmission of a reflected optical signal from the external environment to an optical receiver on an optical ranging sensor die.

Referring now to FIG. 5, a bottom view of an example optical ranging sensor package 200 is provided. As depicted in FIG. 5, the optical ranging sensor package 200 comprises a redistribution layer 104 configured to provide a plurality of electrical contact points 502 at the bottom surface 100b of the optical ranging sensor package 200. As further depicted in FIG. 5, the cap 208 extends at least partially outside of the outer perimeter 116 of the optical ranging sensor die 100.

As depicted in FIG. 5, the bottom surface 100b of the optical ranging sensor package 200 comprises a plurality of electrical contact points 502. An electrical contact point 502 is any conductive structure or surface configured to interface with an external electrical system and provide a conductive path to an integrated circuit die of an optical ranging sensor package 200. In some embodiments, the plurality of electrical contact points 502 may be redistributed by the redistribution layer 104 to accessible locations. For example, the electrical contact points 502 may be spaced to enable interfacing with an external electrical system without shorting. In addition, in some embodiments, the electrical contact points 502 may be rearranged to align particular signals at particular locations of the optical ranging sensor package 200. In some embodiments, the electrical contact points 502 may comprise solder balls.

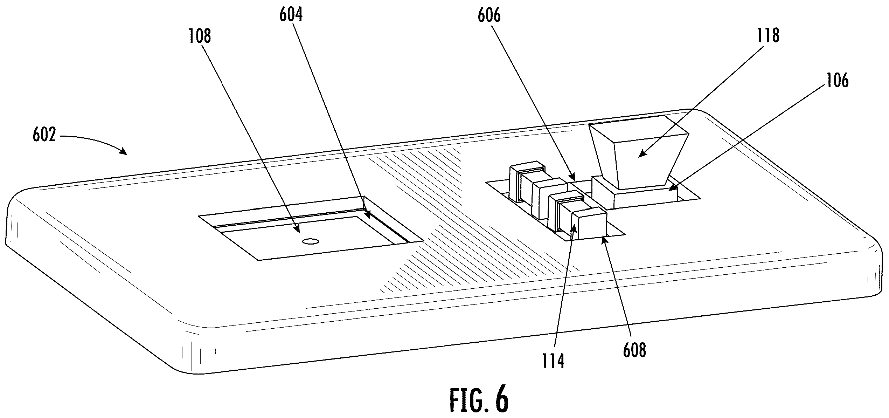

Referring now to FIG. 6, an example protective can 602 covering an optical ranging sensor die (not shown) is provided. As depicted in FIG. 6, the protective can 602 comprises a receiving opening 604, a transmission opening 606, and a component opening 608. The transmission opening 606 is aligned with an optical source 106 of the optical ranging sensor die, such that the transmitted optical signal 118 may pass through the transmission opening 606 to an external environment. The receiving opening 602 is aligned with an optical receiver 108 of the optical ranging sensor die, such that a reflected portion of the optical signal 118 may pass through the receiving opening 602 to the optical receiver. One or more component openings 608 may enable the protective can 602 to fit around one or more electrical components 114, enabling the protective can 602 to have a lower profile.

As depicted in FIG. 6, the protective can 602 may be placed over an optical ranging sensor die (e.g., optical ranging sensor die 100). The protective can 602 may comprise any material configured to cover at least a portion of the optical ranging sensor die to prevent transmission and/or reception of EMI. A protective can 602 may comprise any conductive material to prevent the transmission of EMI, for example, a metal such as tin, stainless steel, aluminum, etc. A protective can 602 may be shaped by a stamping process. Eliminating wire bond connections by attaching the optical source 106 and electrical components 114 to the top surface of the underlying optical integrated circuit die (e.g., integrated circuit die 102 as depicted in FIG. 1) may enable the height of the protective can 602 to be reduced. Creating component openings 608 for taller electrical components 114 may enable further reduction in the height of the protective can 602.

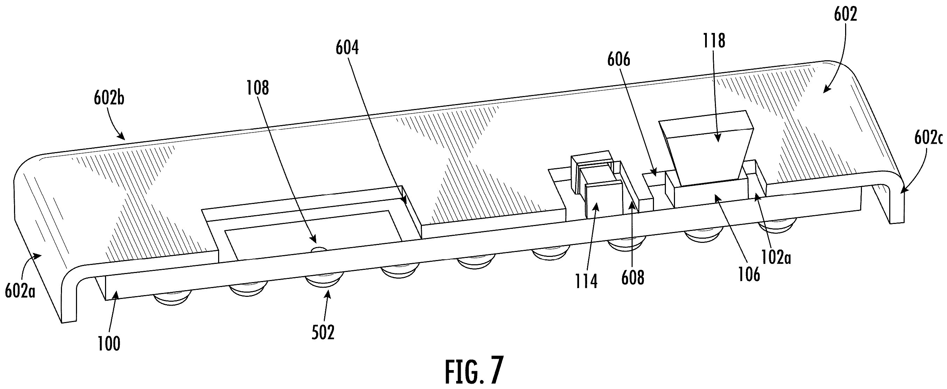

Referring now to FIG. 7, a cross-section view of an optical ranging sensor die 100 covered by a protective can 602 is provided. As depicted in FIG. 7, the optical ranging sensor die 100 includes an optical receiver 108. In addition, an optical source 106 configured to generate an optical signal 118, and various additional electrical components 114 are attached to the top surface 102a of the integrated circuit die 102. The depicted optical ranging sensor die 100 further includes a plurality of electrical contact points 502 providing a conductive path to an integrated circuit at a bottom surface of the optical ranging sensor die 100.

As further depicted in FIG. 7, the optical ranging sensor die 100 is covered by a protective can 602. The protective can 602 substantially covers the top surface 102a and sides of the optical ranging sensor die 100. In the depicted embodiment of FIG. 7, the protective can 602 includes a plurality of sides 602a, 602b, 602c designed to wrap around the sides of the optical ranging sensor die 100. In some embodiments, one or more sides 602a, 602b, 602c of the protective can 602 may attach to an underlying electrical system, for example a printed circuit board.

As further depicted in FIG. 7, the protective can 602 includes a plurality of openings. A receiving opening 604 is aligned with the optical receiver 108 to enable a reflected optical signal 118 to reach the optical receiver 108. A transmission opening 606 is aligned with the optical source 106 to enable attachment of the optical source 106 to the top surface 102a of the integrated circuit die of the optical ranging sensor die 100 and to allow the optical signal 118 to be transmitted toward target objects in an external environment. The protective can 602 further comprises a component opening 608 aligned with one or more electrical components 114. The component opening 608 may enable the protective can 602 to maintain a low profile even in an instance in which electrical components 114 are attached to the top surface 102a of the integrated circuit die of the optical ranging sensor die 100.

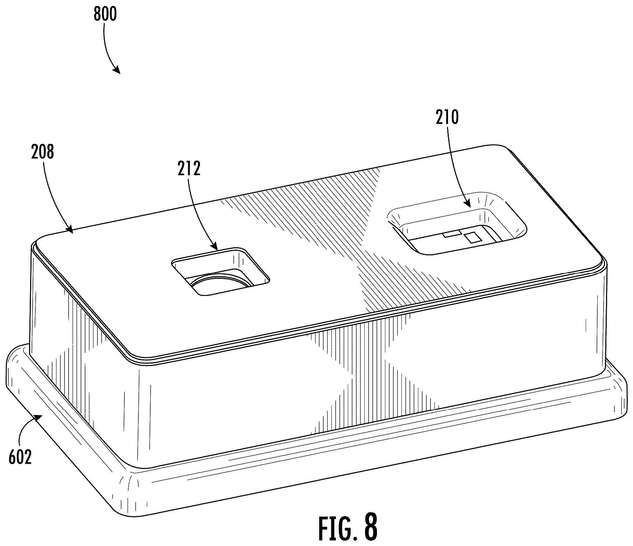

Referring now to FIG. 8, a perspective view of an optical ranging sensor package 800 comprising a protective can 602 and a cap 208 is provided. As depicted in FIG. 8, the cap 208 is attached to a top surface of the protective can 602. As further depicted in FIG. 8, the cap 208 includes a cap transmission opening 210 and a cap receiving opening 212. The cap 208 is attached such that the cap transmission opening 210 is aligned with a transmission opening (e.g., transmission opening 606) of the protective can 602 and an optical source (e.g., optical source 106). Further, the cap receiving opening 212 is aligned with the receiving opening (e.g., receiving opening 604) of the protective can 602 and an optical receiver (e.g., optical receiver 108).

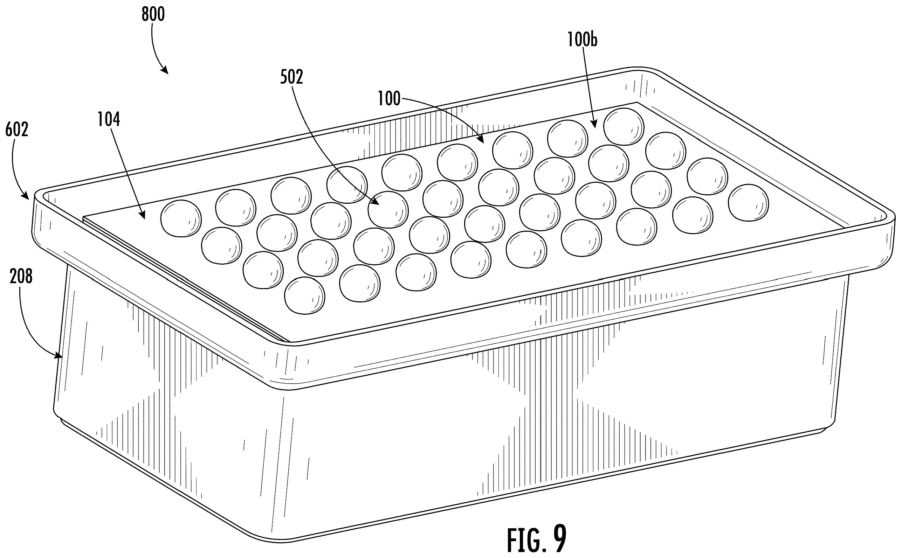

Referring now to FIG. 9, a bottom perspective view of an example optical ranging sensor package 800 is depicted. As depicted in FIG. 9, the example optical ranging sensor package 800 includes an optical ranging sensor die 100 comprising a bottom surface 100b. The redistribution layer 104 comprising a plurality of electrical contact points 502 are depicted in the bottom perspective view. As further depicted in FIG. 9, the protective can 602 is designed to cover the top and side surfaces of the optical ranging sensor die 100. However, the bottom surface 100b and electrical contact points 502 are exposed. The exposed electrical contact points 502 enable electrical connections to an integrated circuit die (e.g., integrated circuit die 102) included with the optical ranging sensor die 100. As such, the electrical contact points 502 may interface with an external electrical system (e.g., a PCB) providing electrical connections to various components in the electrical system.

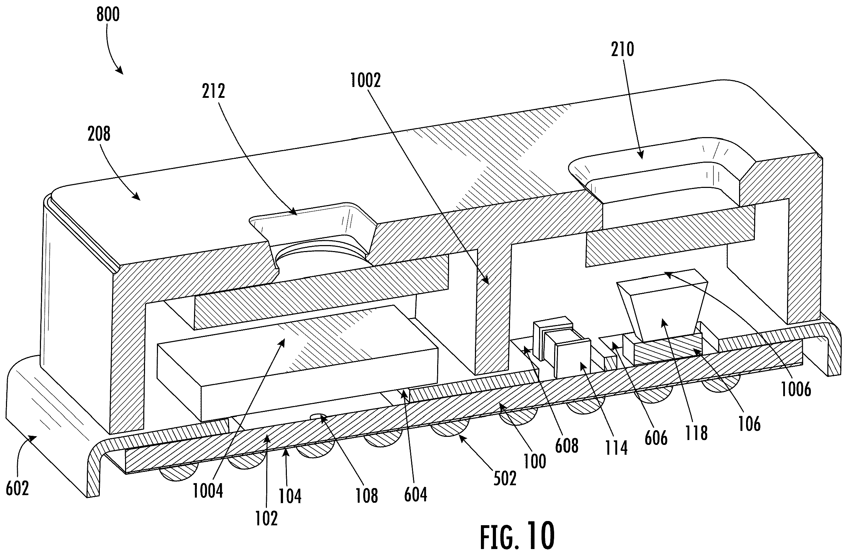

Referring now to FIG. 10, a cross-section view of an example optical ranging sensor package 800 is provided. As depicted in FIG. 10, the example optical ranging sensor package 800 includes a cap 208 attached to a protective can 602 which is covering an optical ranging sensor die 100. The optical ranging sensor die 100 comprising an integrated circuit die 102 and a redistribution layer 104.

As depicted in FIG. 10, the integrated circuit die 102 includes an optical receiver 108. In addition, an optical source 106 and electrical components 114 are attached to a top surface of the integrated circuit die 102. A plurality of electrical contact points 502 are exposed at a bottom surface of the optical ranging sensor die 100 by the redistribution layer 104.

As further depicted in FIG. 10, the optical ranging sensor package 800 includes a protective can 602 covering the optical ranging sensor die 100 and a cap 208 attached to the protective can 602. A cap transmission opening 210 in the cap 208 and a transmission opening 606 in the protective can 602 form a path through which an optical signal 118 may be transmitted into an external environment. Further, a cap receiving opening 212 in the cap 208 and a receiving opening 604 in the protective can 602 form a path through which a reflected optical signal 118 may be received from an external environment at the optical receiver 108.

As further depicted in FIG. 10, the cap 208 includes a barrier wall 1002. A barrier wall 1002 comprises any barrier, obstruction, wall, or other structure configured to divide the interior of the optical ranging sensor package 800 into an optical receiver cavity 1004 and an optical source cavity 1006. The barrier wall 1002 may provide an opaque barrier preventing the optical signal 118 from traveling directly from the optical source cavity 1006 to the optical receiver cavity 1004. The optical source cavity 1006 comprises the portion of the optical ranging sensor package 800 including the optical source 106. The optical receiver cavity 1004 comprises the portion of the optical ranging sensor package 800 including the optical receiver 108.

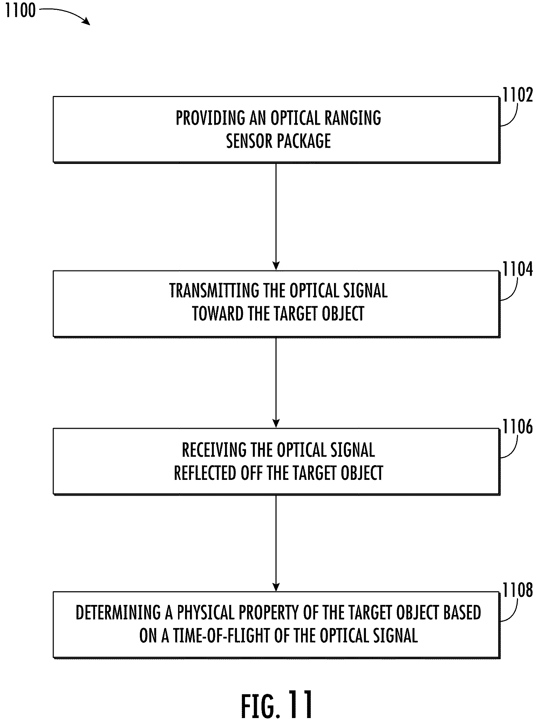

Referring now to FIG. 11, a process 1100 for determining a physical property of a target object using an optical ranging sensor package (e.g., optical ranging sensor package 200, 800) is provided. At block 1102, the optical ranging sensor package is provided. The optical ranging sensor package comprising an optical ranging sensor die (e.g., optical ranging sensor die 100), a protective can (e.g., protective can 602), and a cap (e.g., cap 208). The optical ranging sensor die comprising an integrated circuit die (e.g., integrated circuit die 102), wherein the integrated circuit die further comprises a first surface (e.g., top surface 102a) comprising an optical source contact surface (e.g., optical source contact surface 112), and an optical receiver (e.g., optical receiver 108); and a second surface (e.g., bottom surface 102b). The integrated circuit die further comprises one or more sides (e.g., sides 102c - 102f) defining an outer perimeter (e.g., outer perimeter 116). The outer perimeter of the integrated circuit die defining an outer boundary of the optical ranging sensor die. The optical ranging sensor die further comprising an optical source (e.g., optical source 106) electrically connected to the optical source contact surface and configured to generate an optical signal (e.g., optical signal 118). The protective can covering at least a portion of the first surface of the optical ranging sensor die. The protective can comprising a transmission opening aligned with the optical source; and a receiving opening aligned with the optical receiver. The cap being attached to the protective can.

At block 1104, an optical signal (e.g., optical signal 118) is transmitted toward the target object. The optical signal may pass through a transmission opening 606 in the protective can 602 and a cap transmission opening 210 in the cap 208 to be transmitted into an external environment. In some embodiments, the optical path out of the optical ranging sensor package may include one or more lenses, one or more filters, and/or one or more other optical structures.

A target object comprises any object, structure, surface, or plurality of objects or structures, in an external environment within the field-of-view of the optical ranging sensor package. In such an embodiment, a physical property of the target object may include a speed of the target object, a distance to the target object, an target object type (e.g., wall, chair, toy, etc.), a target object material (e.g., wood, metal, fabric, etc.), or other similar physical property of the target object. An optical signal is any electromagnetic wave generated by an optical source comprising a precisely controlled frequency, phase, wavelength, and/or amplitude. In some embodiments, the optical signal may comprise infrared light. In some embodiments, the optical signal 118 may be transmitted as a chirp or pulse.

At block 1106, a portion of the optical signal reflected off a target object is received at the optical ranging sensor die. The portion of the reflected optical signal may be received at the optical receiver 108 through a receiving opening 212 in the cap 208 and a receiving opening 604 in the protective can 602. In some embodiments, one or more filters, lenses, or other optical structures may be applied to the optical signal received at the optical ranging sensor package.

At block 1108, a physical property of the target object may be determined based on a time-of-flight of the optical signal. A portion of the optical signal may be transmitted directly to a reference array (e.g., reference array 110) within the optical source cavity (e.g., optical source cavity 1006). By comparing the physical properties of the reflected optical signal (e.g., phase offset, amplitude, frequency) to the physical properties of the optical signal received at the reference array, an optical ranging sensor may determine various physical properties of a target object in the field of view of the optical ranging sensor.

While this detailed description has set forth some embodiments of the present invention, the appended claims cover other embodiments of the present invention which differ from the described embodiments according to various modifications and improvements. For example, one skilled in the art may recognize that such principles may be applied to any electronic device that may benefit from detecting presence and/or motion of target objects proximate the electronic device. For example, robotic vacuums, robotic mops, robotic lawn mowers, smart speakers, virtual assistants, motion detect lights, motion detect cameras, household appliances, smart thermostats, and so on.

Within the appended claims, unless the specific term "means for" or "step for" is used within a given claim, it is not intended that the claim be interpreted under 35 U.S.C. 112, paragraph 6.

Use of broader terms such as "comprises," "includes," and "having" should be understood to provide support for narrower terms such as "consisting of," "consisting essentially of," and "comprised substantially of" Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. An optical ranging sensor die comprising:
∘ an integrated circuit die comprising:
▪ a first surface comprising:
• an optical source contact surface; and
• an optical receiver;
▪ a second surface opposite the first surface; and
▪ one or more sides defining an outer perimeter, wherein the outer perimeter of the integrated circuit die defines an outer boundary of the optical ranging sensor die; and
∘ an optical source electrically connected to the optical source contact surface and configured to transmit an optical signal toward a target object;
∘ wherein a physical property of the target object is determined based on the optical signal received at the optical receiver.

2. **The** optical ranging sensor die according to claim 1, wherein the optical source is electrically connected to the optical source contact surface of the integrated circuit die in a flip-chip configuration.

3. **The** optical ranging sensor die according to claim 1 or 2, wherein the optical source comprises a vertical-cavity surface-emitting laser (VCSEL).

4. **The** optical ranging sensor die according to any one of claims 1 to 3, wherein the integrated circuit die is manufactured using a wafer-level chip-scale process.

5. **The** optical ranging sensor die according to any one of claims 1 to 4, wherein the first surface comprises an optical source portion and an optical receiver portion, and wherein one or more electrical components are attached to the optical source portion of the first surface.

6. **The** optical ranging sensor die according to any one of claims 1 to 5, further comprising:
∘ a redistribution layer, wherein the redistribution layer is attached to the second surface of the integrated circuit die.

7. **The** optical ranging sensor die of claim 6, wherein a bottom surface of the redistribution layer comprises one or more electrical contact points electrically connected to the integrated circuit die.

8. An optical ranging sensor package comprising:
∘ the optical ranging sensor die according to any one of claims 1 to 7;
∘ a protective can covering at least a portion of the first surface of the optical ranging sensor die, the protective can comprising:
▪ a transmission opening aligned with the optical source; and
▪ a receiving opening aligned with the optical receiver; and
∘ a cap attached to the protective can.

9. The optical ranging sensor package according to claim 8, wherein the cap comprises:
▪ a transmission cavity comprising a cap transmission opening,
• wherein the cap transmission opening is aligned with the transmission opening of the protective can; and
▪ a receiving cavity comprising a cap receiving opening,
• wherein the cap receiving opening is aligned with the receiving opening of the protective can.

10. The optical ranging sensor package according to claim 9, wherein the cap further comprises a barrier wall dividing the transmission cavity from the receiving cavity.

11. The optical ranging sensor package according to any one of claims 8 to 10, wherein the one or more electrical contact points are electrically connected to a printed circuit board.

12. The optical ranging sensor package according to any one of claims 8 to 11, wherein the protective can is attached to the printed circuit board.

13. The optical ranging sensor package according to any one of claims 8 to 12, wherein the protective can comprises kovar.

14. A method for determining a physical property of a target object, the method comprising:
∘ providing an optical ranging sensor package comprising:
• an optical ranging sensor die comprising:
• an integrated circuit die comprising:
- a first surface comprising:
▪ an optical source contact surface; and
▪ an optical receiver;
- a second surface opposite the first surface; and
- one or more sides defining an outer perimeter, wherein the outer perimeter of the integrated circuit die defines an outer boundary of the optical ranging sensor die; and
• an optical source electrically connected to the optical source contact surface and configured to generate an optical signal;
▪ a protective can covering at least a portion of the first surface of the optical ranging sensor die, the protective can comprising:
• a transmission opening aligned with the optical source; and
• a receiving opening aligned with the optical receiver; and
▪ a cap attached to the protective can;
∘ transmitting the optical signal toward the target object;
∘ receiving the optical signal reflected off the target object; and
∘ determining the physical property of the target object based on a time-of-flight of the optical signal.
